(19) Europäisches Patentamt
European Patent Office
Office européen des brevets

(11) **EP 4 138 303 A1**

(12) **EUROPEAN PATENT APPLICATION**
published in accordance with Art. 153(4) EPC

(43) Date of publication:
**22.02.2023 Bulletin 2023/08**

(51) International Patent Classification (IPC):
**H03M 1/10** *(2006.01)*

(21) Application number: **21828258.0**

(52) Cooperative Patent Classification (CPC):
**H03M 1/10; H03M 1/12**

(22) Date of filing: **27.05.2021**

(86) International application number:
**PCT/CN2021/096555**

(87) International publication number:
**WO 2021/258987 (30.12.2021 Gazette 2021/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.06.2020 CN 202010575519**

(71) Applicant: **Sanechips Technology Co., Ltd.**
**Shenzhen, Guangdong 518055 (CN)**

(72) Inventor: **LUO, Xin**
**Shenzhen, Guangdong 518057 (CN)**

(74) Representative: **Murgitroyd & Company**
**Murgitroyd House**
**165-169 Scotland Street**
**Glasgow G5 8PL (GB)**

(54) **CALIBRATION METHOD, CALIBRATION APPARATUS, TIME INTERLEAVED ADC, ELECTRONIC DEVICE, AND READABLE MEDIUM**

(57) The present disclosure relates to the field of communication devices and provides a method and apparatus for calibrating a sampling timing skew between time-interleaved analog to digital converter (ADC) channels, a time-interleaved ADC, an electronic device, and a computer readable medium. The time-interleaved ADC includes a plurality of ADC channels. The method includes: calculating, for every two adjacent channels, a correlation value between digital signals of two adjacent channels, according to the digital signals output by every two adjacent channels; calculating a timing skew adjustment amount corresponding to a sampling timing skew of each of the channels relative to a reference channel according to the correlation value corresponding to every two adjacent channels, the reference channel being any designated channel among the plurality of channels; and calibrating the sampling timing skew of each of the channels relative to the reference channel according to the timing skew adjustment amount corresponding to each of the channels.

FIG. 1

**Description**

**CROSS REFERENCE TO RELATED APPLICATIONS**

The present disclosure is filed based on Chinese patent application No. 202010575519.8 filed on June 22, 2020, and claims priority of the Chinese patent application. The entire content of the Chinese patent application is hereby incorporated into the present disclosure by reference.

**TECHNICAL FIELD**

Embodiments of the present disclosure relate to the field of communication devices, and in particular to a method and an apparatus for calibrating a sampling timing skew between channels of a time-interleaved analog to digital converter, ADC, a time-interleaved ADC, TIADC, an electronic device, and a computer readable medium.

**BACKGROUND**

In recent years, with the development of information technology, requirements for high-speed and high-precision ADCs in fields of wireless communication, high-precision instrumentation and wired transmission are getting higher and higher. Affected by technique and design level of an integrated circuit, it is generally difficult for a conventional single-channel ADC to achieve high speed and high precision requirements at the same time. A time-interleaved technology that enables multiple single-channel ADCs to work in parallel is an effective method to improve the conversion rate of the ADCs, and has received more and more attention and adoption in recent years.

A TIADC adopts an architecture in which multiple single-channel ADCs work alternately in an orderly manner, which can multiply the conversion rate of the ADCs, but system performance of a TIADC system is poor.

**SUMMARY**

A main objective of the embodiments of the present disclosure is to provide a method and an apparatus for calibrating a sampling timing skew between channels of a time-interleaved ADC, a TIADC, an electronic device, and a computer-readable medium.

In order to achieve the above objective, the method for calibrating a sampling timing skew between channels of a TIADC is provided according to some embodiments of the present disclosure. The method includes the following operations: calculating, for every two adjacent channels in multiple ADC channels, a correlation value between digital signals of two adjacent channels according to the digital signals output by every two adjacent channels; calculating a timing skew adjustment amount corresponding to a sampling timing skew of each of the multiple ADC channels relative to a reference channel according to the correlation value corresponding to every two adjacent channels, where the reference channel is any designated channel among the multiple ADC channels; calibrating the sampling timing skew of each of the multiple ADC channels relative to the reference channel according to the timing skew adjustment amount corresponding to each of the multiple ADC channels.

In order to achieve the above objective, some embodiments of the present disclosure further provide a calibration apparatus for calibrating a sampling timing skew between channels of the TIADC. The calibration apparatus includes a correlation value calculation unit, a timing skew adjustment calculation unit, and a calibration unit. The correlation value calculation unit is configured to calculate, for every two adjacent channels in multiple ADC channels, a correlation value between digital signals of every two adjacent channels according to the digital signals output by every two adjacent channels. The timing skew adjustment calculation unit is configured to calculate a timing skew adjustment amount corresponding to a sampling timing skew of each of the multiple ADC channels relative to a reference channel according to the correlation value corresponding to every two adjacent channels, where the reference channel is any designated channel among the multiple ADC channels. The calibration unit is configured to calibrate the sampling timing skew of each of the multiple ADC channels relative to the reference channel according to the timing skew adjustment amount corresponding to each of the multiple ADC channels.

In order to achieve the above objective, some embodiments of the present disclosure further provide a TIADC, which includes multiple ADC channels and the above calibration apparatus.

In order to achieve the above objective, some embodiments of the present disclosure further provide an electronic device, which includes: one or more processors; a memory storing one or more programs that, when executed by the one or more processors, causes the one or more processors to perform the above calibration method; one or more input/output (I/O) interfaces, which connect the one or more processors to the memory, and is configured to realize information interaction between the one or more processors and the memory.

In order to achieve the above objective, some embodiments of the present disclosure further provide a computer-readable medium storing a computer program that, when executed, performs the above calibration method.

**BRIEF DESCRIPTION OF THE DRAWINGS**

FIG. 1 is a flowchart of a method for calibrating a sampling timing skew between channels in a TIADC provided according to a first embodiment of the present disclosure;

FIG. 2 is a flowchart of a method for calibrating a sampling timing skew between channels in a TIADC provided according to a second embodiment of the present disclosure;

FIG. 3 is a flowchart of a specific implementation of operation 22 in FIG. 2;

FIG. 4 is a flowchart of a specific implementation of operation 23 in FIG. 2;

FIG. 5 is a flowchart of obtaining a correspondence relationship between a correlation value and a timing skew characteristic amount;

FIG. 6 is a flowchart of calculating an unknown constant $R'(T_S)$;

FIG. 7 is a schematic diagram of a signal to noise and distortion ratio, SNDR curve of digital signals output by a TIADC under different analog signal frequencies;

FIG. 8 is a schematic diagram of a SNDR curve of digital signals output by a TIADC under different sampling timing skew standard deviations;

FIG. 9 is a schematic diagram of a frequency spectrum of digital signals output before calibration;

FIG. 10 is a schematic diagram of a frequency spectrum of digital signals output after calibration;

FIG. 11 is a simulation schematic diagram of convergence of residue sampling timing skew after calibration;

FIG. 12 is a block diagram showing a composition of a calibration apparatus provided according to a third embodiment of the present disclosure;

FIG. 13 is a schematic structural diagram of a TIADC provided according to an embodiment of the present disclosure.

**DETAILED DESCRIPTION OF THE EMBODIMENTS**

In order to make those skilled in the art better understand the technical solution of the embodiments of the present disclosure, a method and an apparatus for calibrating a sampling timing skew between channels of a TIADC, a TIADC, an electronic device, and a computer readable medium provided according to the embodiments of the present disclosure are described in detail below with reference to the accompanying drawings.

Herein, the accompanying drawings are used to provide a further understanding of the embodiments of the present disclosure and constitute a part of the specification. Together with the embodiments of the present disclosure, the accompanying drawings are used to explain the present disclosure, and do not constitute a limitation on the present disclosure.

Exemplary embodiments are described more fully hereinafter with reference to the accompanying drawings, but the exemplary embodiments may be embodied in different forms and should not be construed as limited to the embodiments set forth herein. Rather, these embodiments are provided so that the present disclosure will be thorough and complete, and will fully convey the scope of the present disclosure to those skilled in the art. Various embodiments of the present disclosure and various features of the embodiments may be combined with each other in a case without conflict.

The terms used herein are used to describe particular embodiments only and are not intended to limit the present disclosure. As used herein, "first", "second", and similar terms do not denote any order, quantity, or importance, but are merely used to distinguish various components. Likewise, the singular forms "a", "an", and "the" are intended to include the plural forms as well, unless the context clearly dictates otherwise. It will be further understood that the terms "includes," "including," "comprises," and/or "comprising," when used in this specification, specify the presence of stated features, integers, steps, operations, elements, and/or components, but do not preclude the presence or addition of one or more other features, integers, steps, operations, elements, components, and/or groups thereof. Words like "connected" or "connecting" are not limited to physical or mechanical connections, but may include electrical connections, whether direct or indirect. "Up", "down", "left", "right", etc. are only used to represent a relative positional relationship, and when an absolute position of the described object changes, the relative positional relationship may also change accordingly.

Embodiments described herein may be described with reference to plan and/or cross-sectional views with the aid of idealized schematic diagrams of the present disclosure. Accordingly, exemplary drawings may be modified according to manufacturing techniques and/or tolerances. Therefore, the embodiments are not limited to the embodiments shown in the accompanying drawings, but include modifications of configurations formed based on a manufacturing process. Thus, regions illustrated in the accompanying drawings have schematic properties and shapes of regions illustrated in the drawings exemplifies specific shapes of regions of elements and are not intended to be limitative.

Unless otherwise defined, all terms (including technical and scientific terms) used herein have the same meaning as commonly understood by those of ordinary skill in the art. It will also be understood that terms such as those defined in common dictionaries should be construed as having meanings consistent with their meanings in the context of the related art and the present disclosure, and will not be construed as having idealized or over-formal meanings, unless clearly limited herein.

In the embodiments of the present disclosure, affected by the manufacturing process, temperature changes, environmental disturbances, etc., an architecture of the TIADC has a disadvantage of mismatch between channels, mainly including three error sources, that is, offset mismatch, gain mismatch, and sampling time mismatch between the channels. An error caused by the error sources can significantly degrade performance of the TIADC system. Herein, performance degradation caused by the sampling time mismatch between the channels is strongly related to a signal frequency, and becomes a main factor limiting performance of the TIADC in a high frequency part.

Therefore, in order to effectively solve the problem of performance degradation of the TIADC system caused by the sampling time mismatch, the embodiments of the present disclosure provide a method and an apparatus for calibrating the sampling timing skew between channels in the TIADC, a TIADC, an electronic device, and a computer readable medium.

The technical solution of the embodiments of the present disclosure will be described in further detail below with reference to the embodiments and the accompanying drawings.

First embodiment

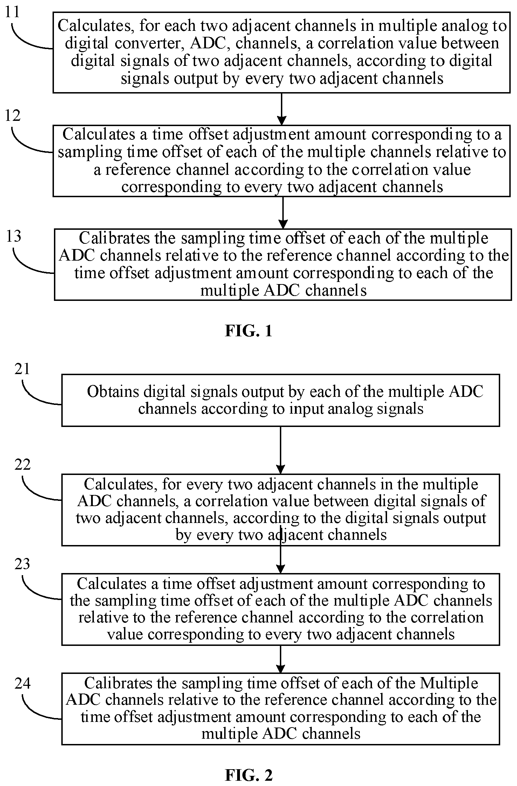

As shown in FIG. 1, the first embodiment of the present disclosure provides a method for calibrating a sampling timing skew between channels of the TIADC, where the TIADC includes multiple ADC channels, and the method includes the following operations 11 to 13.

In operation 11, for every two adjacent channels in the multiple ADC channels, a correlation value between digital signals of every two adjacent channels is calculated according to the digital signals output by every two adjacent channels.

In operation 12, a timing skew adjustment amount corresponding to a sampling timing skew of each of the multiple ADC channels relative to a reference channel is calculated according to the correlation value corresponding to every two adjacent channels in the multiple ADC channels, where the reference channel is any designated channel among the multiple ADC channels.

In operation 13, the sampling timing skew of each of the multiple ADC channels relative to the reference channel is calibrated according to the timing skew adjustment amount corresponding to each of the multiple ADC channels.

The method for calibrating the sampling timing skew between channels of the TIADC provided according to this embodiment can be applied to a TIADC including any number of channels. The correlation value between the digital signals of every two adjacent channels in the multiple ADC channels is calculated, and the timing skew adjustment amount corresponding to the sampling timing skew of each of the multiple ADC channels relative to the reference channel is obtained from the correlation value, and the sampling time of each of the multiple ADC channels is calibrated based on the timing skew adjustment amount of each of the multiple ADC channels. In this way, the sampling timing skew between channels of the TIADC is calibrated, and system performance of the TIADC is effectively improved.

Second embodiment

As shown in FIG. 2, the second embodiment of the present disclosure provides a method for calibrating a sampling timing skew between channels of the TIADC, where the TIADC includes multiple ADC channels, and the method includes the following operations 21 to 24.

In operation 21, digital signals output by each of the multiple ADC channels according to input analog signals are obtained.

In this embodiment, the TIADC includes N ADC channels (N≥2), a sampling rate of each of the multiple ADC channels is fs/N, where fs is a clock frequency of the TIADC. A sampling time interval of each of the multiple ADC channels is NTs, where Ts is a sampling clock period of the TIADC, and Ts=1/fs. A sampling clock of each of the multiple ADC channels is provided by a clock signal CLK corresponding to a sampling switch S/H of each of the multiple ADC channels.

After an analog signal x(t) at an input end of the TIADC is received, the TIADC performs an analog-to-digital conversion on the analog signal x(t) to generate a digital output of each of the multiple ADC channels. A digital signal output by each of the multiple ADC channels is $Y = \{y_1[k], y_2[k], \cdots, y_i[k], \cdots, y_N[k]\}$, where $y_i[k]$ represents a kth digital signal output by an ith channel, i=1, 2, 3, ...., N, N is the number of the ADC channels of the TIADC; k=0, 1, 2, ..., L, L is the number of sampling points in a single channel. Herein, N ADC channels sample and hold the input analog signal x(t) at the sampling time interval NTS alternatively.

In this embodiment, a relationship between the digital signal output by the $i_{th}$ channel and an analog signal x(ti) corresponding to the ith channel is: $y_i[k]=x(NkT_S + (i-1)T_S + \tau_i)$, where ti is an actual sampling time of the ith channel, $t_i = NkT_S + (i-1) T_S+\tau_i$ , $\tau_i$ is an actual sampling timing skew amount (sampling time mismatch) of the ith channel relative to the reference channel. Herein, a matrix of a relationship between the kth digital signal output by each of the channels and the analog signals x(ti) corresponding to each of the multiple ADC channels is expressed as follows:

$$\begin{pmatrix} y_1[k] \\ y_2[k] \\ \vdots \\ y_i[k] \\ \vdots \\ y_{N-1}[k] \\ y_N[k] \end{pmatrix} = \begin{pmatrix} x(NkT_s + \tau_1) \\ x(NkT_s + T_s + \tau_2) \\ \vdots \\ x(NkT_s + (i-1)T_s + \tau_i) \\ \vdots \\ x(NkT_s + (N-2)T_s + \tau_{N-1}) \\ x(NkT_s + (N-1)T_s + \tau_N) \end{pmatrix}$$

In this embodiment, in response to setting a hth (h = 1, 2, 3, N-1 or N) channel as the reference channel, rh=0. For example, in response to setting a first channel as the reference channel, $\tau1=\tau N+1=0$. In response to setting other channels as the reference channel, for example, in response to setting a second channel as the reference channel, $\tau2=0$. Similarly, in response to setting a third channel as the reference channel, $\tau3=0$, and the like. In response to setting the hth channel as the reference channel, $\tau h=0$.

In operation 22, for every two adjacent channels in the multiple ADC channels, a correlation value between digital signals of every two adjacent channels is calculated according to the digital signals output by every two adjacent channels.

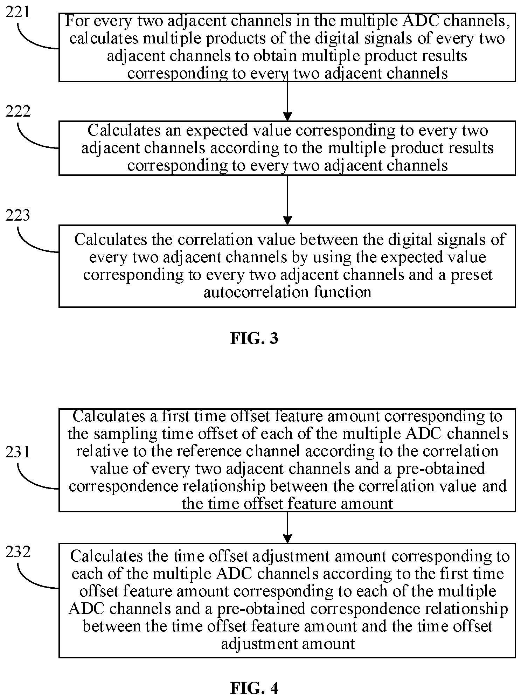

In this embodiment, for every two adjacent channels in the multiple ADC channels, the correlation value between the digital signals of every two adjacent channels is calculated by using a preset autocorrelation function according to the digital signals of every two adjacent channels. As shown in FIG. 3, operation 22 includes the following operations 221 to 223.

In operation 221, for every two adjacent channels in the multiple ADC channels, multiple products of the digital signals of every two adjacent channels are calculated to obtain multiple product results corresponding to every two adjacent channels.

Herein, $r_{i, i+1}[k] = y_i[k] * y_{i+1}[k]$, $y_i[k]$ represents a digital signal output by an ith channel, $y_{i+1}[k]$ represents a kth digital signal output by an i+1th channel, $r_{i, i+1}[k]$ represents a kth product result corresponding to the ith channel and the i+1th channel, i=1, 2, 3, ...., N, where N is the number of channels in the time-interleaved ADC; k=0, 1, 2,..., L, where L is the number of sampling points in a single channel; in response to i=N, a N+1th channel is a first channel, $r_{N, N+1}[k] = y_N[k] * y_1[k + 1]$. A matrix of the product results corresponding to every two adjacent channels in the multiple ADC channels is expressed as follows:

$$\begin{pmatrix} r_{1,2}[k] \\ r_{2,3}[k] \\ \vdots \\ r_{i,i+1}[k] \\ \vdots \\ r_{N-1,N}[k] \\ r_{N,N+1}[k] \end{pmatrix} = \begin{pmatrix} y_1[k] * y_2[k] \\ y_2[k] * y_3[k] \\ \vdots \\ y_i[k] * y_{i+1}[k] \\ \vdots \\ y_{N-1}[k] * y_N[k] \\ y_N[k] * y_1[k+1] \end{pmatrix}$$

In operation 222, an expectation value corresponding to every two adjacent channels is calculated according to the multiple product results corresponding to every two adjacent channels.

In this embodiment, a weighted average is performed on the multiple product results corresponding to every two adjacent channels, and a weighted average result is used as the expectation value corresponding to every two adjacent channels. The weighted average may adopt a method of accumulating and summing average or a method of moving average. The method of accumulating and summing average is to obtain the expectation value corresponding to every two adjacent channels by calculating an average value in the multiple product results corresponding to every two adjacent channels, that is, the average value is the expectation value. The method of moving average is to calculate the expectation value corresponding to every two adjacent channels by using a preset moving average model according to the multiple product results corresponding to every two adjacent channels. The moving average model includes a formula: $R[k] = (1 - \alpha)*R[k - 1] + \alpha*r[k]$ $a$ is a smoothing coefficient, $r[k]$ is a product result calculated in a kth period, $R[k]$ is an expectation value calculated in the kth period , and $R[k - 1]$ is an expectation value calculated in a $k-1th$ period.

In operation 223, the correlation value between the digital signals of every two adjacent channels is calculated by using the expectation value corresponding to every two adjacent channels and the preset autocorrelation function.

The autocorrelation function is: $R_{i, i+1} = E (r_{i, i+1}[k]) = E (y_i[k]* y_{i+1}[k])$ , $R_{i, i+1}$ represents a correlation value between digital signals of the ith channel and the i+1th channel, and $E (r_{i, i+1}[k])$ represents an expectation value corresponding to the ith channel and the i+1th channel.

In this embodiment, the generation of analog signals is a stationary process. According to properties of an autocorrelation function of the stationary process, it can be known that the correlation value between the digital signals of the $i+1_{th}$ channel and the i+1th channel is:

$$R_{i,\ i+1} = E\ (x\ (NkT_S +(i-1)\ T_S + \tau_i)* x\ (NkT_S + i*T_S + \tau_{i+1})\ ) = R\ (T_S + \tau_{i+1} - \tau_i)$$

where, $R (T_S +\tau_{i+1} -\tau_i)$ is a value of the autocorrelation function R at $T_S+\tau_{i+1}-\tau_i$, and $T_S+\tau_{i+1}-\tau_i$ is a difference between an actual sampling time of the i+1th channel and the actual sampling time of the ith channel.

In operation 23, a timing skew adjustment amount corresponding to the sampling timing skew of each of the multiple ADC channels relative to the reference channel is calculated according to the correlation value corresponding to every two adjacent channels in the multiple ADC channels, where the reference channel is any designated channel among the multiple ADC channels.

As shown in FIG. 4, operation 23 includes operation 231 and operation 232.

In operation 231, a first timing skew characteristic amount corresponding to the sampling timing skew of each of the multiple ADC channels relative to the reference channel is calculated according to the correlation value of every two adjacent channels in the multiple ADC channels and a pre-obtained correspondence relationship between the correlation value and the timing skew characteristic amount.

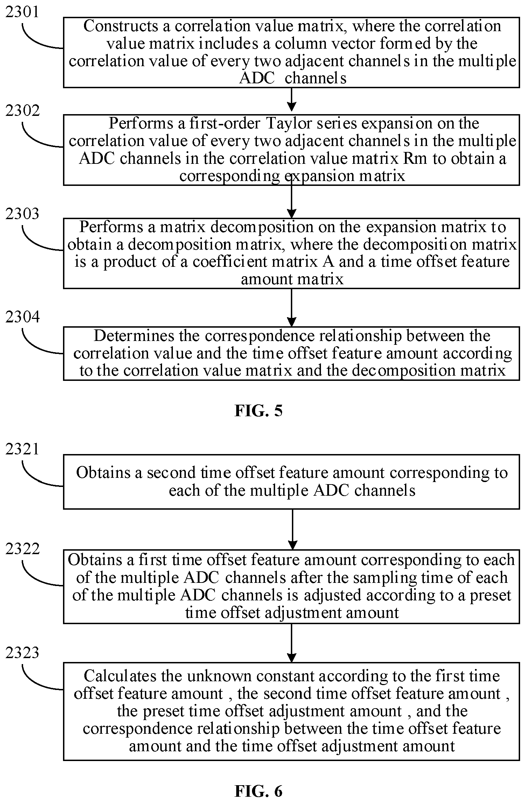

As shown in FIG. 5, the correspondence relationship between the correlation value and the timing skew characteristic amount is obtained through the following operations 2301 to 2304.

In operation 2301, a correlation value matrix is constructed, where the correlation value matrix includes a column vector formed by the correlation value between every two adjacent channels of the multiple ADC channels.

The correlation value matrix is:

$$Rm = \begin{pmatrix} R_{1,2} \\ R_{2,3} \\ \vdots \\ R_{i,i+1} \\ \vdots \\ R_{N-1,N} \\ R_{N,1} \end{pmatrix} = \begin{pmatrix} R(T_s + \tau_2 - \tau_1) \\ R(T_s + \tau_3 - \tau_2) \\ \vdots \\ R(T_s + \tau_{i+1} - \tau_i) \\ \vdots \\ R(T_s + \tau_N - \tau_{N-1}) \\ R(T_s + \tau_1 - \tau_N) \end{pmatrix},$$

where $R_{i, i+1}$ is the correlation value corresponding to the ith channel and the i+1th channel.

In operation 2302, a first-order Taylor series expansion is performed on the correlation value between every two adjacent channels of the multiple ADC channels in the correlation value matrix Rm to obtain a corresponding expansion matrix.

A first -order Taylor series expansion equation of the correlation value $R_{i, i+1}$ corresponding to the ith channel and the i+1th channel is: $R_{i,i+1} = R(T + \tau_{i+1} - \tau_i) - R(T_S) + R'(T_S)* (\tau_{i+1} -\tau_i)$, where $R'(T_S)$ is a derivative of the autocorrelation function $R$ at $T_S$, $R'(T_S)$ is an unknown constant, and the expansion matrix is:

$$Dm = \begin{pmatrix} R(T_s) + R'(T_s)*(\tau_2 - \tau_1) \\ R(T_s) + R'(T_s)*(\tau_3 - \tau_2) \\ \vdots \\ R(T_s) + R'(T_s)*(\tau_{i+1} - \tau_i) \\ \vdots \\ R(T_s) + R'(T_s)*(\tau_N - \tau_{N-1}) \\ R(T_s) + R'(T_s)*(\tau_1 - \tau_N) \end{pmatrix}$$

In operation 2303, a matrix decomposition is performed on the expansion matrix Dm to obtain a decomposition matrix, where the decomposition matrix is a product of a coefficient matrix A and a timing skew characteristic amount matrix.

$$\phi m = \begin{pmatrix} R\ (T_S) \\ R'(T_s)*\tau_1 \\ R'(T_s)*\tau_2 \\ \vdots \\ R'(T_s)*\tau_{h-1} \\ R'(T_s)*\tau_{h+1} \\ \vdots \\ R'(T_s)*\tau_N \end{pmatrix}$$

Herein, the timing skew characteristic amount matrix is: , the coefficient matrix A is a constant matrix with N rows and N columns, and a product of each of the rows of the coefficient matrix A and the timing skew characteristic amount matrix $\phi$m equals to an element corresponding to each of the N rows in the expansion matrix Dm.

It can be understood that in response to setting the first channel as the reference channel, $\tau_1 = 0$, the timing

$$\phi m = \begin{pmatrix} R\ (T_S) \\ R'(T_s)*\tau_2 \\ R'(T_s)*\tau_3 \\ \vdots \\ R'(T_s)*\tau_N \end{pmatrix}$$

skew characteristic amount matrix is: , correspondingly, the coefficient matrix A is:

$$A = \begin{pmatrix} 1 & 1 & 0 & \cdots & 0 \\ 1 & -1 & 1 & \cdots & 0 \\ 1 & 0 & -1 & \cdots & 0 \\ \vdots & \vdots & \vdots & \ddots & 1 \\ 1 & 0 & \cdots & \cdots & -1 \end{pmatrix}$$

; in response to setting the second channel as the reference channel, $\tau 2 = 0$,

$$\phi \, m = \begin{pmatrix} R\ (T_S) \\ R'(T_s)*\tau_1 \\ R'(T_s)*\tau_3 \\ \vdots \\ R'(T_s)*\tau_N \end{pmatrix}$$, correspondingly, the coefficient matrix A is: $$A = \begin{pmatrix} 1 & -1 & 0 & \cdots & 0 \\ 1 & 0 & 1 & \cdots & 0 \\ 1 & 0 & -1 & \cdots & 0 \\ \vdots & \vdots & \vdots & \ddots & 1 \\ 1 & 0 & \cdots & \cdots & -1 \end{pmatrix}$$; in response

to setting the third channel as the reference channel, $\tau 3=0$, $$\phi \, m = \begin{pmatrix} R\ (T_S) \\ R'(T_s)*\tau_1 \\ R'(T_s)*\tau_2 \\ R'(T_s)*\tau_4 \\ \vdots \\ R'(T_s)*\tau_N \end{pmatrix}$$, correspondingly, the coefficient

matrix A is: $$A = \begin{pmatrix} 1 & -1 & 1 & \cdots & 0 \\ 1 & 0 & -1 & \cdots & 0 \\ 1 & 0 & 0 & \cdots & 0 \\ \vdots & \vdots & \vdots & \ddots & 1 \\ 1 & 0 & \cdots & \cdots & -1 \end{pmatrix}$$; and the like. The product of each of the rows in the coefficient matrix A and the timing skew characteristic amount matrix $\phi m$ is equal to the element corresponding to each of the N rows in the expansion matrix Dm, that is, the first-order Taylor series expansion equation of a corresponding row.

In operation 2304, the correspondence relationship between the correlation value and the timing skew characteristic amount is determined according to the correlation value matrix Rm and the decomposition matrix.

In an embodiment, a relationship between the correlation value matrix Rm and the decomposition matrix can be obtained according to the above operations 2301 to 2303, that is:

$$\begin{pmatrix} R_{1,2} \\ R_{2,3} \\ \vdots \\ R_{i,i+1} \\ \vdots \\ R_{N-1,N} \\ R_{N,1} \end{pmatrix} = A * \begin{pmatrix} R\ (T_S) \\ R'(T_s)*\tau_1 \\ R'(T_s)*\tau_2 \\ \vdots \\ R'(T_s)*\tau_{h-1} \\ R'(T_s)*\tau_{h+1} \\ \vdots \\ R'(T_s)*\tau_N \end{pmatrix}$$

The timing skew characteristic amount is defined as: $\Phi_j = R'(T_S)* \tau_j$, and the correspondence relationship between the correlation value and the timing skew characteristic amount can be obtained, where the correspondence relationship between the correlation value and the timing skew characteristic amount is:

$$\begin{pmatrix} R(T_s) \\ \phi_1 \\ \phi_2 \\ \vdots \\ \phi_{h-1} \\ \phi_{h+1} \\ \vdots \\ \phi_N \end{pmatrix} = INV(A)* \begin{pmatrix} R_{1,2} \\ R_{2,3} \\ \vdots \\ R_{i,i+1} \\ \vdots \\ R_{N-1,N} \\ R_{N,1} \end{pmatrix}$$

, $INV(A)$ is an inverse matrix of the coefficient matrix A, $\phi_j = R'(T_S)*\tau_j$ (j=1,2 , ...,h-1,h+1,...,N), $\phi_j$ represents a first timing skew characteristic amount corresponding to a jth channel, $\tau_j$ represents an actual sampling timing skew amount corresponding to the jth channel.

In operation 232, the timing skew adjustment amount corresponding to each of the multiple ADC channels is calculated according to the first timing skew characteristic amount corresponding to each of the multiple ADC channels and a pre-obtained correspondence relationship between the timing skew characteristic amount and the timing skew adjustment amount.

The correspondence relationship between the timing skew characteristic amount and the timing skew adjustment amount can be obtained in the following manner: determining the correspondence relationship between the timing skew characteristic amount and the timing skew adjustment amount according to the timing skew characteristic amount matrix.

In an embodiment, according to the timing skew characteristic amount matrix, it can be known that the timing skew characteristic amount $\phi_j$ and the actual sampling timing skew amount $\tau_j$ have a linear relationship, and a ratio of the timing skew characteristic amount $\phi_j$ and the actual sampling timing skew amount $\tau_j$ is the constant $R'(T_S)$. Based on this, the correspondence relationship between the timing skew characteristic amount $\phi_i$ and the timing skew adjustment amount is constructed. The correspondence relationship between the timing skew characteristic amount and the timing skew adjustment amount is: $\phi_j = R'(T_S)*Dsk_j$, $Dsk_j$ is a timing skew adjustment amount corresponding to the jth channel.

In some embodiments, the timing skew adjustment amount is calculated according to the correspondence relationship between the timing skew characteristic amount and the timing skew adjustment amount by calculating a value of the unknown constant $R'(T_S)$. As shown in FIG. 6, the value of the unknown constant $R'(T_S)$ can be obtained through the following operations 2321 to 2323.

In operation 2321, a second timing skew characteristic amount $\phi_{old}$ corresponding to each of the multiple ADC channels is obtained.

In an embodiment, after the correlation value corresponding to every two adjacent channels in the multiple ADC channels is calculated by using historical digital signals output by each of the multiple ADC channels and adopting the above calculation method for the correlation value, the correspondence relationship between the above correlation value and the timing skew characteristic amount is used to calculate a second timing skew characteristic amount $\phi_{old}$ corresponding to each of the multiple ADC channels.

In operation 2322, after the sampling time of each of the multiple ADC channels is adjusted according to a preset timing skew adjustment amount $\Delta Dsk$, the first timing skew characteristic amount $\phi_{new}$ corresponding to each of the multiple ADC channels is obtained.

After the second timing skew characteristic amount $\phi_{old}$ corresponding to each of the multiple ADC channels is determined, the sampling time of each of the multiple ADC channels is adjusted according to the preset timing skew adjustment amount $\Delta Dsk$ . Since the reference channel does not have a timing skew, a sampling time of the reference channel does not need to be adjusted. After the sampling time of each of the multiple ADC channels is adjusted according to the preset timing skew adjustment amount $\Delta Dsk$, the above operations 21, 22, and 231 are performed to obtain the first timing skew characteristic amount $\phi_{new}$ corresponding to each of the multiple ADC channels.

In operation 2323, the unknown constant R'(Ts) is calculated according to the first timing skew characteristic amount $\phi_{new}$, the second timing skew characteristic amount $\phi_{old}$, the preset timing skew adjustment amount $\Delta Dsk$, and the correspondence relationship between the timing skew characteristic amount and the timing skew adjustment amount: $\Delta\phi = R'(T_S)* \Delta Dsk$, where $\Delta\phi = \phi_{new} - \phi_{old}$.

According to the above correspondence relationship between the timing skew characteristic amount and the timing skew adjustment amount: $\phi_j = R'(Ts) * Dsk_j$, it can be known that the timing skew characteristic amount and the timing skew adjustment amount have a linear relationship, and variation of the timing skew characteristic amount and variation of the timing skew adjustment amount also satisfy $\Delta\phi = R'(T_S) * \Delta Dsk$ . Thus, it can be known that the unknown constant $R'(T_S) = \Delta\varphi/\Delta Dsk$. Therefore, the unknown constant $R'(T_S)$ can be calculated according to the first timing skew

feature ($\phi_{new}$, the second timing skew feature $\phi_{old}$, the preset timing skew adjustment $\Delta Dsk$ and the correspondence relationship between the timing skew characteristic amount and the timing skew adjustment amount $\Delta\phi = R'(T_S)*\Delta Dsk$.

In a case that the value of the unknown constant $R'(T_S)$ is determined, operation 232 may include: calculating the timing skew adjustment amount corresponding to the sampling time of each of the multiple ADC channels according to the first timing skew characteristic amount $\phi_{new}$ and the corresponding relationship between the timing skew characteristic amount and the timing skew adjustment amount: $\phi_j = R'(T_S) * Dsk_j$; where, $\phi_j$ represents the first timing skew characteristic amount corresponding to the jth channel, and $Dsk_j$ represents the timing skew adjustment corresponding to the jth channel.

In some embodiments, after the first timing skew characteristic amount corresponding to each of the multiple ADC channels and the correspondence relationship between the timing skew characteristic amount and the timing skew adjustment amount are determined, an adaptive algorithm is used to cause the timing skew adjustment amount to approach the actual sampling timing skew amount, so as to estimate a value of the timing skew adjustment amount. In this case, operation 232 includes:

performing, for each of the multiple ADC channels other than the reference channel, an iterative calculation on the timing skew adjustment amount corresponding to the each channel by using a preset adaptive algorithm, according to the first timing skew feature corresponding to the each channel and the pre-obtained correspondence relationship between the timing skew adjustment amount and the timing skew characteristic amount, and taking an iterative calculation result as the timing skew adjustment amount corresponding to the each channel;

where the adaptive algorithm includes a formula:

$$Dsk_j(n+1) = Dsk_j(n) - \mu * \phi_j * \text{sign}\ (R'(T_S))$$

$\mu$ is a preset adjustment coefficient, and sign $(R'(T_S))$ is a sign bit of $R'(T_S)$, the $\phi_j$ represents the timing skew characteristic amount corresponding to the jth channel, $Dsk_j(n)$ represents an actual sampling timing skew amount of the jth channel in a nth adjustment, and $Dsk_j(n + 1)$ represents an actual sampling timing skew amount of the jth channel in a n+1th adjustment; in response to a spectrum of the analog signal located in an even-numbered Nyquist region, sign $(R'(T_S)) = 1$, in response to the spectrum of the analog signal located in an odd-numbered Nyquist region, sign $(R'(T_S)) = -1$.

In an embodiment, for each of the multiple ADC channels other than the reference channel, at an initial stage (n=1), a value of $Dsk_j(1)$ is given, a value of $Dsk_j(2)$ is calculated through the above formula after the first timing skew characteristic amount of the channel is calculated. A value of $Dsk_j(3)$ is calculated through the above formula after the second timing skew characteristic amount of the channel is calculated, and on the like, until the iteration converges. A final convergence value of the iteration, that is, the iterative calculation result, is used as the timing skew adjustment amount corresponding to the channel.

In some embodiments, after the first timing skew characteristic amount corresponding to each of the multiple ADC channels, the correspondence relationship between the timing skew characteristic amount and the timing skew adjustment amount, and the unknown constant $R'(T_S)$ in the correspondence relationship are determined, the adaptive algorithm is used to cause the timing skew adjustment amount to approach the actual sampling timing skew amount, so as to estimate the value of the timing skew adjustment amount. In this case, operation 232 includes: performing, for each of the multiple ADC channels other than the reference channel, an iterative calculation on the timing skew adjustment amount corresponding to the each channel by using a preset adaptive algorithm, according to the first timing skew feature corresponding to the each channel and the pre-obtained correspondence relationship between the timing skew adjustment amount and the timing skew characteristic amount, and taking an iterative calculation result as the timing skew adjustment amount corresponding to the each channel, where, the adaptive algorithm includes the formula:

$$Dsk_j(n+1) = Dsk_j(n) - \mu * \phi_j / R'(T_S)$$

$\mu$ is the preset adjustment coefficient, $\phi_j$ represents the timing skew characteristic amount corresponding to the jth channel, $Dsk_j(n)$ represents the actual sampling timing skew amount of the jth channel in the nth adjustment, and $Dsk_j(n + 1)$ represents the actual sampling timing skew amount of the jth channel in the n+1th adjustment.

The timing skew adjustment amount is calculated by determining the unknown constant $R'(T_S)$ and combining with the adaptive algorithm. In this way, on the one hand, the timing skew adjustment amount can quickly converge to be approach around an optimal value, and on the other hand, variation of the timing skew can be well tracked, and a problem that the unknown constant is difficult to estimate accurately can be overcome.

In operation 24, the sampling timing skew of each of the multiple ADC channels relative to the reference channel is calibrated according to the timing skew adjustment amount corresponding to each of the multiple ADC channels.

In some embodiments, in an analog domain, the sampling time of each of the multiple ADC channels (other than the reference channel) is adjusted according to the timing skew adjustment amount corresponding to each of the multiple ADC channels, so as to compensate the sampling timing skew of each of the multiple ADC channels relative to the reference channel, thereby calibrating the sampling timing skew of each of the multiple ADC channels relative to the reference channel.

In some embodiments, the digital output of each of the multiple ADC channels is interpolated by a preset interpolation algorithm in a digital domain according to the timing skew adjustment amount corresponding to each of the multiple ADC channels, so as to perform an error calibration.

The calibration method of this embodiment is described below by taking a TIADC including two ADC channels (channel 1 and channel 2) as an example.

The channel 1 is taken as the reference channel, a delay mismatch (actual sampling timing skew amount) of the reference channel (channel 1) $\tau_1$ equals 0, a delay mismatch (actual sampling timing skew amount) of the channel 2 relative to the channel 1 is recorded as $\tau_2$, and the digital signals of the two channels are expressed as follows:

$$\begin{pmatrix} y_1[k] \\ y_2[k] \end{pmatrix} = \begin{pmatrix} x(2kT_s) \\ x(2kT_s + T_S + \tau_2) \end{pmatrix}$$

where x ($t_i$) ($t_i = 2KT_S + (i-1) T_S + \tau_i$) is a sampling value of the ith (i=1, 2) channel at the actual sampling time ti. Through the above calculation method of the correlation value, it can be known that the correlation value corresponding to every two adjacent channels in the two channels is:

$$\begin{pmatrix} R_{1,2} \\ R_{2,1} \end{pmatrix} = \begin{pmatrix} E(y_1[k] * y_2[k]) \\ E(y_2[k] * y_1[k+1]) \end{pmatrix} = \begin{pmatrix} R(T_S + \tau_2 - \tau_1) \\ R(T_S + \tau_1 - \tau_2) \end{pmatrix}$$

A first-order Taylor expansion series is used to solve the approximate value of the correlation value, and the correlation values corresponding to every two adjacent channels (channels 1 and 2) can be expressed as:

$$\begin{pmatrix} R_{1,2} \\ R_{2,1} \end{pmatrix} = \begin{pmatrix} R(T_S + \tau_2 - \tau_1) \\ R(T_S + \tau_1 - \tau_2) \end{pmatrix} = \begin{pmatrix} R(T_s) + R'(T_s) * (\tau_2 - \tau_1) \\ R(T_s) + R'(T_s) * (\tau_1 - \tau_2) \end{pmatrix}$$

A matrix decomposition is further performed to obtain the decomposition matrix:

$$\begin{pmatrix} R_{1,2} \\ R_{2,1} \end{pmatrix} = \begin{pmatrix} 1 & 1 \\ 1 & -1 \end{pmatrix} * \begin{pmatrix} R(T_S) \\ R'(T_s) * \tau_2 \end{pmatrix}.$$

The timing skew characteristic amount of the channel 2 relative to the reference channel (the channel 1) is defined as $\phi_2 = R'(T_S) * \tau_2$. The inverse matrix of the above decomposition matrix can be used to solve the equation, and the correspondence relationship between the correlation value and the timing skew characteristic amount of the channel 2 can be determined as:

$$\begin{pmatrix} R(T_S) \\ \phi_2 \end{pmatrix} = INV \begin{pmatrix} 1 & 1 \\ 1 & -1 \end{pmatrix} * \begin{pmatrix} R_{1,2} \\ R_{2,1} \end{pmatrix} = \begin{pmatrix} 0.5 & 0.5 \\ 0.5 & -0.5 \end{pmatrix} * \begin{pmatrix} R_{1,2} \\ R_{2,1} \end{pmatrix}$$

Therefore, the timing skew characteristic amount of the channel 2 is: $\phi_2 = R'(T_S) * \tau_2 = 0.5 * R_{1,2} - 0.5 * R_{2,1}$. The timing skew adjustment amount is used to characterize the actual sampling timing skew amount, then the correspondence relationship between the timing skew characteristic amount and the timing skew adjustment amount of the channel 2 can be determined as: $\phi_2 = R'(T_S) * D\text{sk}_2$, where $D\text{sk}_2$ represents the timing skew adjustment amount corresponding to the channel 2.

After the correlation value corresponding to every two adjacent channels (the channel 1 and the channel 2), the timing skew characteristic amount corresponding to the channel 2 can be calculated from the correspondence relationship between the above correlation value and the timing skew characteristic amount. As for the timing skew adjustment amount, one method is to directly calculate the timing skew adjustment amount by calculating the unknown constant $R'(T_S)$, and then using the above correspondence relationship between the timing skew characteristic amount and the timing skew adjustment amount. For an example calculation method in this case, reference may be made to the above description, and details are not repeated here.

Another method is to use the preset adaptive algorithm to cause the timing skew adjustment amount to approach the actual sampling timing skew amount, or use the preset adaptive algorithm to cause the timing skew adjustment amount approach the actual sampling timing skew amount after the unknown constant $R'(T_S)$ is calculated. For an example process, reference may be made to the above description, and details are not repeated here.

Hereinafter, the calibration method of this embodiment will be described by taking a TIADC including four ADC channels (channels 1, 2, 3, and 4) as an example.

The channel 1 is taken as the reference channel, and other channels 2 to 4 are aligned with the channel 1, then the delay mismatch (actual sampling timing skew amount) of the reference channel (the channel 1) $\tau 1$ equals 0, the delay mismatches (actual sampling timing skews) of the channels 2 to 4 relative to the channel 1 are respectively recorded as $\tau 2$ to $\tau 4$. Then digital signals of the channels 1 to 4 are expressed as follows:

$$\begin{pmatrix} y_1[k] \\ y_2[k] \\ y_3[k] \\ y_4[k] \end{pmatrix} = \begin{pmatrix} x(4kT_s) \\ x(4kT_s + T_s + \tau_2) \\ x(4kT_s + 2T_s + \tau_3) \\ x(4kT_s + 3T_s + \tau_4) \end{pmatrix}$$

where x $C t_i$) ($t_i = 4KT_S + (i-1) T_S + \tau_i$) is the sampling value of the ith (i=1, 2, 3, 4) channel at the actual sampling time $t_i$. Through the above calculation method of the correlation value, it can be known that the correlation value corresponding to every two adjacent channels in the channels 1 to 4 is:

$$\begin{pmatrix} R_{1,2} \\ R_{2,3} \\ R_{3,4} \\ R_{4,1} \end{pmatrix} = \begin{pmatrix} E(y_1[k] * y_2[k]) \\ E(y_2[k] * y_3[k]) \\ E(y_3[k] * y_4[k]) \\ E(y_4[k] * y_1[k+1]) \end{pmatrix} = \begin{pmatrix} R(T_s + \tau_2 - \tau_1) \\ R(T_s + \tau_3 - \tau_2) \\ R(T_s + \tau_4 - \tau_3) \\ R(T_s + \tau_1 - \tau_4) \end{pmatrix}$$

A first-order Taylor expansion series is used to solve the approximate value of the correlation value, and the correlation value of every two adjacent channels can be expressed as:

$$\begin{pmatrix} R_{1,2} \\ R_{2,3} \\ R_{3,4} \\ R_{4,1} \end{pmatrix} = \begin{pmatrix} R(T_s + \tau_2 - \tau_1) \\ R(T_s + \tau_3 - \tau_2) \\ R(T_s + \tau_4 - \tau_3) \\ R(T_s + \tau_1 - \tau_4) \end{pmatrix} = \begin{pmatrix} R(T_s) + R'(T_s) * \tau_2 \\ R(T_s) + R'(T_s) * (\tau_3 - \tau_2) \\ R(T_s) + R'(T_s) * (\tau_4 - \tau_3) \\ R(T_s) + R'(T_s) * \tau_4 \end{pmatrix}$$

A matrix decomposition is further performed to obtain the decomposition matrix:

$$\begin{pmatrix} 1 & 1 & 0 & 0 \\ 1 & -1 & 1 & 0 \\ 1 & 0 & -1 & 1 \\ 1 & 0 & 0 & -1 \end{pmatrix} * \begin{pmatrix} R(T_s) \\ R'(T_s)*\tau_2 \\ R'(T_s)*\tau_3 \\ R'(T_s)*\tau_4 \end{pmatrix}.$$

A timing skew characteristic amount of the channel 2 relative to the reference channel is defined as $\phi_2 = R'(T_S)*\tau_2$, a timing skew characteristic amount of the channel 3 relative to the reference channel is defined as $\phi_3 = R'(T_S) * \tau_3$, and a timing skew characteristic amount of the channel 4 relative to the reference channel is defined as $\phi_4 = R'(T_S) * \tau_4$. By using the inverse matrix to solve the above decomposition matrix, the correspondence relationship between the correlation value and the timing skew characteristic amount can be determined as:

$$\begin{pmatrix} \phi_2 \\ \phi_3 \\ \phi_4 \end{pmatrix} = \begin{pmatrix} 0.75 & -0.25 & -0.25 & -0.25 \\ 0.5 & 0.5 & -0.5 & -0.5 \\ 0.25 & 0.25 & 0.25 & -0.75 \end{pmatrix} * \begin{pmatrix} R_{1,2} \\ R_{2,3} \\ R_{3,4} \\ R_{4,1} \end{pmatrix}$$

By using the timing skew adjustment amount to characterize the actual sampling timing skew amount, the correspondence relationship between the timing skew characteristic amount and the timing skew adjustment amount can be determined as:

$$\begin{pmatrix} \phi_2 \\ \phi_3 \\ \phi_4 \end{pmatrix} = R'(T_S) * \begin{pmatrix} Dsk_2 \\ Dsk_3 \\ Dsk_4 \end{pmatrix}$$

where, $Dsk_2$ represents a timing skew adjustment amount corresponding to the channel 2, $Dsk_3$ represents a timing skew adjustment amount corresponding to the channel 3, and $Dsk_4$ represents a timing skew adjustment amount corresponding to the channel 4.

After the correlation value corresponding to every two adjacent channels is calculated, the timing skew characteristic amounts corresponding to the channel 2, the channel 3 and the channel 3 respectively can be calculated from the above correspondence relationship between the correlation value and timing skew characteristic amount.

As for the timing skew adjustment amount, one method is to directly calculate the timing skew adjustment amount by calculating the unknown constant $R'(T_S)$ and then using the above correspondence relationship between the timing skew characteristic amount and the timing skew adjustment amount. For the calculation method of this situation, for example, reference may be made to the above description, and details are not repeated here.

Another method is to use the preset adaptive algorithm to cause the timing skew adjustment amount to approach the actual sampling timing skew amount, or use the preset adaptive algorithm to cause the timing skew adjustment to approach the actual sampling timing skew after the unknown constant $R'(T_S)$ is calculated. For an example process, reference may be made to the above description, and details are not repeated here.

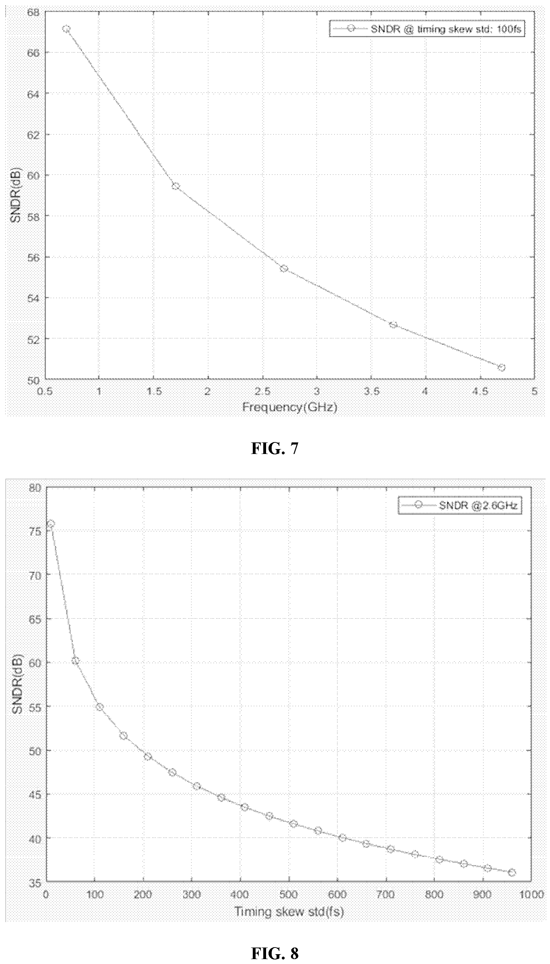

To illustrate the calibration effect of the calibration method in this embodiment, a TIADC including 4 channels, having a sampling rate of 6 GHz and a resolution of 13 bits, is taken as an example, where a minimum calibration step size is set to 10 femtoseconds. FIG. 7 shows a SNDR curve of output signals of the TIADC at different analog signal frequencies when an actual sampling timing skew standard deviation, timing skew std, between channels is fixed at 100 femtoseconds. FIG. 8 shows a relationship between a SNDR of the digital signal output by a TIADC varies as the sampling timing skew std between channels varies in response to setting a frequency of the analog signal to 2.6GHz. It can be seen from FIG. 7 that the higher the frequency of the analog signal, the greater the loss of SNDR performance caused by the sampling timing skew. It can be seen from FIG. 8 that the greater the sampling timing skew, the greater the loss of SNDR performance.

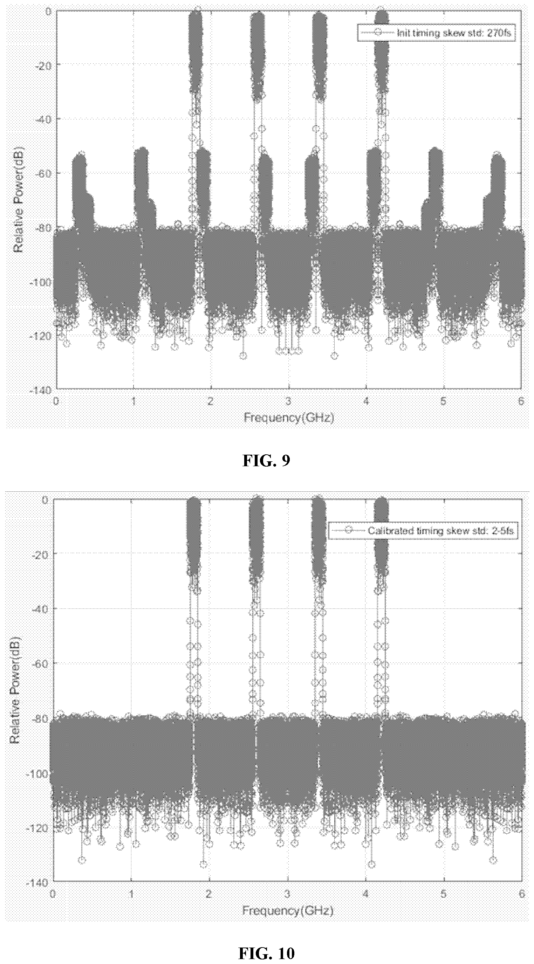

The calibration effect is further illustrated by taking a broadband radio frequency signal as an example. The input analog signals are located in two frequency bands, center frequencies are 1.8GHz and 2.6GHz respectively, both bandwidths are 200MHz, and a sampling timing skew std is 270 femtoseconds at initial. FIG. 9 shows a spectrum of the signals before calibration, and FIG. 10 shows a spectrum of the signals after calibration. Comparing FIG. 9 with FIG. 10, it can be seen that the system performance has been significantly improved after calibration. Before calibration, a spur caused by timing skew mismatch reaches about 50dBc. After calibration, the timing skew mismatch is basically eliminated, and corresponding spur and noise floor are at the same level.

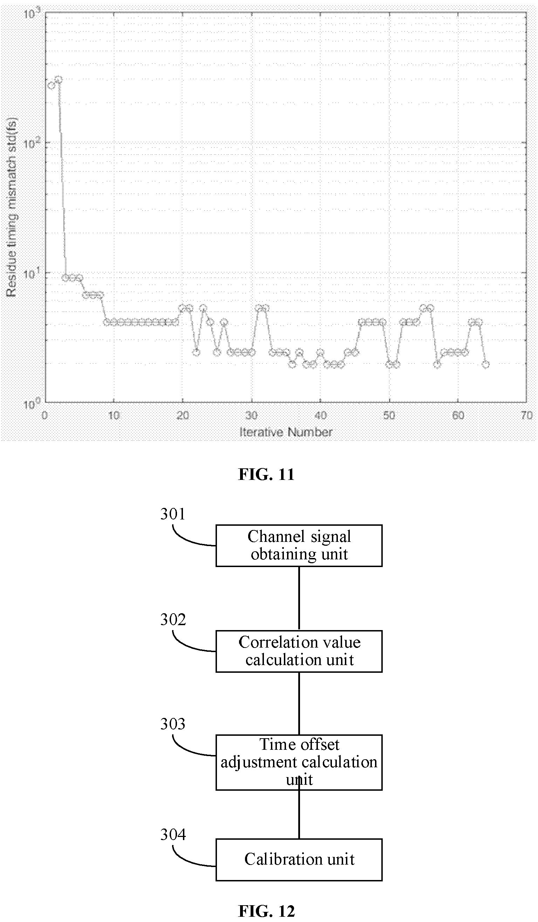

FIG. 11 shows a simulation schematic diagram of convergence of residue sampling timing skew after calibration. As can be seen from the figure, the sampling timing skew std is approximately 270 femtoseconds at initial, which increases slightly after a first fixed adjustment, and the system performance has been significantly improved after a quick adjustment, with a residue timing skew reduced to approximately 10 femtoseconds. After several iterations, the performance basically converges, and limited by the calibration step size of 10 femtoseconds, the residue timing skew std in the figure oscillates between 2 to5 femtoseconds.

Third embodiment

As shown in FIG. 12, the third embodiment of the present disclosure provides a calibration apparatus for calibrating a sampling timing skew between channels of a TIADC. The calibration apparatus includes a channel signal obtaining unit 301, a correlation value calculation unit 302, a timing skew adjustment calculation unit 303 and a calibration unit 304.

The channel signal obtaining unit 301 is configured to obtain digital signals output by each of the multiple ADC channels according to input analog signals. The correlation value calculation unit 302 is configured to calculate, for every two adjacent channels in the multiple ADC channels, a correlation value between digital signals of every two adjacent channels according to the digital signals output by every two adjacent channels. The timing skew adjustment calculation unit 303 is configured to calculate a timing skew adjustment amount corresponding to a sampling timing skew of each of the channels relative to a reference channel according to the correlation value corresponding to every two adjacent channels, where the reference channel is any designated channel among the multiple ADC channels. The calibration unit 304 is configured to calibrate the sampling timing skew of each of the multiple ADC channels relative to the reference channel according to the timing skew adjustment amount corresponding to each of the multiple ADC channels.

In addition, the calibration apparatus provided in this embodiment is configured to perform the calibration method provided in the first embodiment or the second embodiment. For relevant description, reference may be made to the description of the first embodiment or the second embodiment, and details are not repeated here.

Fourth embodiment

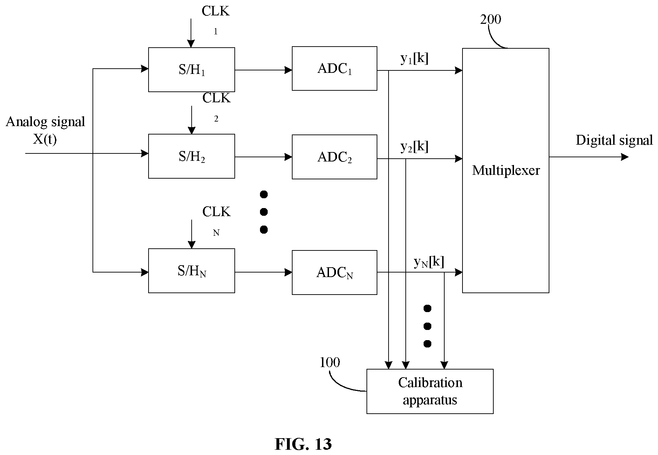

As shown in FIG. 13, the fourth embodiment of the present disclosure provides a TIADC, where the TIADC includes multiple ADC channels (ADC1 to ADCN) and a calibration apparatus 100. The calibration apparatus includes the calibration apparatus provided according to the above third embodiment. For the description of the calibration apparatus, for example, reference may be made to the description of the third embodiment, and details are not repeated here.

In addition, in this embodiment, the TIADC further includes a multiplexer 200 for interleaving outputs of the N ADC channels, so as to generate digital outputs according to a sampling rate.

In this embodiment, each of the multiple ADC channels is correspondingly provided with a sampling switch, and the sampling switch is configured to connect or disconnect an analog signal input end to an input end of a corresponding ADC channel, and each sampling switch is recorded as S/H1 to S/HN. Each sampling switch is controlled by a corresponding sampling clock, and each sampling clock is recorded as CLK1 to CLKN.

Fifth embodiment

The fifth embodiment of the present disclosure provides an electronic device, including: one or more processors; a memory storing one or more programs that, when executed by the one or more processors, causes the one or more processors to perform the above calibration method; one or more input/output (I/O) interfaces connecting the one or more processors to the memory, and configured to realize information interaction between the one or more processors and the memory.

Sixth embodiment

The sixth embodiment of the present disclosure provides a computer-readable medium storing a computer program that, when executed, performs the above calibration method.

Those of ordinary skill in the art can understand that all or some of the operations, system, functional modules/units of the apparatus in the methods disclosed above may be implemented as software, firmware, hardware, and appropriate combinations thereof.

In a hardware implementation, the division between functional modules/units mentioned in the above description does not necessarily correspond to the division of physical components. For example, a physical component may have multiple functions, or a function or operation may be performed by several physical components cooperatively. Some or all of the physical components may be implemented as software executed by a processor, such as a central processor, a digital signal processor or a microprocessor, or as hardware, or as an integrated circuit, such as an application specific integrated circuit. Such software may be distributed on a computer-readable medium, and the computer-readable medium may include a computer storage medium (or non-transitory medium) and a communication medium (or transitory medium). As known to those of ordinary skill in the art, the term computer storage medium includes volatile or non-volatile, removable or non-removable medium used in any method or technology for storing information (such as computer-readable instructions, data structures, computer program modules, or other data). The computer storage medium include but are not limited to a random access memory, RAM, a read-only memory, ROM, an electrically erasable programmable read only memory, EEPROM, a flash memory or other storage technologies, a compact disc read-only memory, CD-ROM, a digital versatile disk, DVD or other optical disk storage, a magnetic cassette, a magnetic tape, a magnetic disk storage or other magnetic storage devices, or any other medium used to store desired information and that may be accessed by a computer. In addition, as known to those of ordinary skill in the art, the communication medium typically includes computer readable instructions, data structures, program modules, or other data in modulated data signals such as carrier waves or other transport mechanisms and may include any information delivery medium.

Exemplary embodiments have been disclosed herein, and although specific terms are employed, they are used and should only be construed in a general descriptive sense and not for purpose of limitation. In some instances, it will be apparent to those skilled in the art that features, characteristics and/or elements described in connection with a particular embodiment may be used alone or in combination with features, characteristics and/or elements in connection with other embodiments, unless expressly stated otherwise. Accordingly, it will be understood by those of ordinary skill in the art that various changes in form and details may be made therein without departing from the scope of the present disclosure as set forth in the appended claims.

## Claims

1. A method for calibrating a sampling timing skew between channels of a time-interleaved analog to digital converter, ADC, comprising a plurality of ADC channels, wherein the method comprises:

   calculating, for every two adjacent channels in the plurality of ADC channels, a correlation value between digital signals of every two adjacent channels according to the digital signals output by every two adjacent channels;
   calculating a timing skew adjustment amount corresponding to the sampling timing skew of each in the plurality of ADC channels relative to a reference channel according to the correlation value corresponding to every two adjacent channels, wherein the reference channel is any designated channel among the plurality of ADC channels;
   calibrating the sampling timing skew of each in the plurality of ADC channels relative to the reference channel according to the timing skew adjustment amount corresponding to each in the plurality of ADC channels.

2. The method according to claim 1, wherein calculating, for every two adjacent channels in the plurality of ADC channels, a correlation value between digital signals of every two adjacent channels according to the digital signals output by every two adjacent channels comprises:

   calculating, for every two adjacent channels in the plurality of ADC channels, a plurality of products of the digital signals of every two adjacent channels to obtain a plurality of product results corresponding to every two adjacent channels; wherein $r_{i,\ i+1}[k] = y_i[k] * y_{i+1}[k]$, $y_i[k]$ represents a $k_{th}$ digital signal output by an $i_{th}$ channel, $y_{i+1}[k]$ represents a $k_{th}$ digital signal output by an $i+1_{th}$ channel, $r_{i,\ i+1}[k]$ represents a $k_{th}$ product result corresponding to the $i_{th}$ channel and the $i+1_{th}$ channel, i=1, 2, 3, ...., N, wherein N is a number of channels in the time-interleaved ADC; k=0, 1, 2,..., L, wherein L is a number of sampling points in a single channel; in response to i=N, a $N+1_{th}$ channel is a first channel, $r_{N,\ N+1}[k] = y_N[k] * y_1[k+1]$;
   calculating an expectation value corresponding to every two adjacent channels according to the plurality of the product results corresponding to every two adjacent channels;
   calculating the correlation value between the digital signals of every two adjacent channels by using the expectation value corresponding to every two adjacent channels and a preset autocorrelation function; wherein the autocorrelation function is: $R_{i,\ i+1} = E(r_{i,\ i+1}[k])$, $R_{i,\ i+1}$ represents a correlation value between digital signals of

the $i_{th}$ channel and the $i+1_{th}$ channel, $E$ ($r_{i,\ i+1}[k]$) represents an expectation value corresponding to the $i_{th}$ channel and the $i+1_{th}$ channel.

3. The method according to claim 1, wherein calculating the timing skew adjustment amount corresponding to the sampling timing skew of each in the plurality of ADC channels relative to the reference channel according to the correlation value corresponding to every two adjacent channels in the plurality of ADC channels comprises:

calculating a first timing skew characteristic amount corresponding to the sampling timing skew of each in the plurality of ADC channels relative to the reference channel, according to the correlation value of every two adjacent channels in the plurality of ADC channels and a pre-obtained correspondence relationship between the correlation value and a timing skew characteristic amount;
calculating the timing skew adjustment amount corresponding to each in the plurality of ADC channels, according to the first timing skew characteristic amount corresponding to each in the plurality of ADC channels and a pre-obtained correspondence relationship between the timing skew characteristic amount and the timing skew adjustment amount.

4. The method according to claim 3, wherein a relationship between a $k_{th}$ digital signal $y_i[k]$ output by an $i_{th}$ channel and an analog signal x(ti) input by the TIADC is: $y_i[k] = x\ (t_i)$ , wherein ti is an actual sampling time of the $i_{th}$ channel, $t_i = NkT_S + (i - 1)\ T_S + \tau_i$, $T_S$ is a sampling clock period of the ADC, $NT_S$ is a sampling time interval of each of the plurality ADC channels, and $\tau_i$ is an actual sampling timing skew amount of the $i_{th}$ channel relative to the reference channel; in response to setting a $h_{th}$ channel (h=1, 2, ..., N-1 or N) as the reference channel, $\tau_h$=0;
a correlation value between the digital signals of the $i_{th}$ channel and an $i+1_{th}$ channel is: $R_{i,\ i+1} = E\ (y_i[k]^*y_{i+1}[k]) = R\ (T_S +\tau_{i+1} - \tau_i)$, wherein $R\ (T_S +\tau_{i+1} - \tau_i)$ is a value of a autocorrelation function at $T_S +\tau_{i+1} -\tau_i$, and $T_S +\tau_{i+1} - \tau_i$ is a difference between an actual sampling time of the $i+1_{th}$ channel and the actual sampling time of the $i_{th}$ channel.

5. The method according to claim 4, wherein the correspondence relationship between the correlation value and the timing skew characteristic amount timing skew is obtained by the following operations:

constructing a correlation value matrix comprising a column vector formed by the correlation value between every two adjacent channels in the plurality of ADC channels; wherein the correlation value matrix is:

$$Rm = \begin{pmatrix} R_{1,2} \\ R_{2,3} \\ \vdots \\ R_{i,i+1} \\ \vdots \\ R_{N-1,N} \\ R_{N,1} \end{pmatrix} = \begin{pmatrix} R(T_s + \tau_2 - \tau_1) \\ R(T_s + \tau_3 - \tau_3) \\ \vdots \\ R(T_s + \tau_{i+1} - \tau_i) \\ \vdots \\ R(T_s + \tau_N - \tau_{N-1}) \\ R(T_s + \tau_1 - \tau_N) \end{pmatrix}$$

, $R_{i,i+1}$ is the correlation value corresponding to the $i_{th}$ channel and the $i+1_{th}$ channel;
performing a first-order Taylor series expansion on the correlation value between every two adjacent channels in the plurality of ADC channels in the correlation value matrix Rm, to obtain a corresponding expansion matrix;

$$Dm = \begin{pmatrix} R(T_s) + R'(T_s)*(\tau_2 - \tau_1) \\ R(T_s) + R'(T_s)*(\tau_3 - \tau_2) \\ \vdots \\ R(T_s) + R'(T_s)*(\tau_{i+1} - \tau_i) \\ \vdots \\ R(T_s) + R'(T_s)*(\tau_N - \tau_{N-1}) \\ R(T_s) + R'(T_s)*(\tau_1 - \tau_N) \end{pmatrix}$$

wherein the expansion matrix is: , $R'(T_S)$ is a derivative of the autocorrelation function R at $T_S$, and $R'(T_S)$ is an unknown constant;
performing a matrix decomposition on the expansion matrix *Dm* to obtain a decomposition matrix, wherein the decomposition matrix is a product of a coefficient matrix A and a timing skew characteristic amount matrix;

$$\phi m = \begin{pmatrix} R(T_S) \\ R'(T_s) * \tau_1 \\ R'(T_s) * \tau_2 \\ \vdots \\ R'(T_s) * \tau_{h-1} \\ R'(T_s) * \tau_{h+1} \\ \vdots \\ R'(T_s) * \tau_N \end{pmatrix}$$

wherein the timing skew characteristic amount matrix is: , and the coefficient matrix $A$ is a constant matrix with $N$ rows and $N$ columns, a product of each of the $N$ rows in the coefficient matrix $A$ and the timing skew characteristic amount matrix $\Phi_m$ equals to an element corresponding to each of the $N$ rows in the expansion matrix $Dm$;

determining the correspondence relationship between the correlation value and the timing skew characteristic amount according to the correlation value matrix Rm and the decomposition matrix; wherein the correspondence relationship between the correlation value and the timing skew characteristic amount is:

$$\begin{pmatrix} R(T_s) \\ \phi_1 \\ \phi_2 \\ \vdots \\ \phi_{h-1} \\ \phi_{h+1} \\ \vdots \\ \phi_N \end{pmatrix} = INV(A) * \begin{pmatrix} R_{1,2} \\ R_{2,3} \\ \vdots \\ R_{i,i+1} \\ \vdots \\ R_{N-1,N} \\ R_{N,1} \end{pmatrix}$$

, $INV(A)$ is an inverse matrix of the coefficient matrix $A$, $\phi_j = R'(T_S) * \tau_j$ (j=1,2,...,h-1,h+1,...,N), $\phi_j$ represents a first timing skew characteristic amount corresponding to a $j_{th}$ channel, and $\tau_j$ represents an actual sampling timing skew amount corresponding to the $j_{th}$ channel.

6. The method according to claim 5, wherein the correspondence relationship between the timing skew characteristic amount and the timing skew adjustment amount is obtained in the following operation:
determining the correspondence relationship between the timing skew characteristic amount and the timing skew adjustment amount according to the timing skew characteristic amount matrix; wherein the correspondence relationship between the timing skew characteristic amount and the timing skew adjustment amount is: $\phi_j = R'(T_S) * Dsk_j$, $Dsk_j$ is a timing skew adjustment amount corresponding to the $j_{th}$ channel.

7. The method according to claim 6, wherein before calculating the timing skew adjustment amount corresponding to each in the plurality of ADC channels, according to the first timing skew characteristic amount corresponding to each in the plurality of ADC channels and the pre-obtained correspondence relationship between the timing skew characteristic amount and the timing skew adjustment amount, the method further comprises:

obtaining a second timing skew characteristic amount $\phi_{old}$ corresponding to each in the plurality of ADC channels;
obtaining the first timing skew characteristic amount $\phi_{new}$ corresponding to each in the plurality of ADC channels after the sampling time of each in the plurality of ADC channels is adjusted according to a preset timing skew adjustment amount $\Delta Dsk$;
calculating the unknown constant $R'(T_S)$ according to the first timing skew characteristic amount ($\phi_{new}$, the second timing skew characteristic amount $\phi_{old}$, the preset timing skew adjustment amount $\Delta Dsk$, and the correspondence relationship between the timing skew characteristic amount and the timing skew adjustment amount: $\Delta\phi = R'(T_S) * \Delta Dsk$ wherein $\Delta\phi = \phi_{new} - \phi_{old}$;
calculating the timing skew adjustment amount corresponding to each in the plurality of ADC channels according to the first timing skew characteristic amount corresponding to each in the plurality of ADC channels and the pre-obtained correspondence relationship between the timing skew adjustment amount and the timing skew characteristic amount comprises: calculating the timing skew adjustment amount corresponding to the sampling time of each in the plurality of ADC channels according to the first timing skew characteristic amount $\phi_{new}$ and the correspondence relationship between the timing skew characteristic amount and the timing skew adjustment amount: $\phi_j = R'(T_S)*D\mathrm{sk}_j$; wherein, the $\phi_j$ represents the first timing skew characteristic amount corresponding to the $j_{th}$ channel, and the $D\mathrm{sk}_j$ represents the timing skew adjustment amount corresponding to the $j_{th}$ channel.

**8.** The method according to claim 6, wherein calculating the timing skew adjustment amount corresponding to each in the plurality of ADC channels according to the first timing skew characteristic amount corresponding to each in the plurality of ADC channels and the pre-obtained correspondence relationship between the timing skew characteristic amount and the timing skew adjustment amount comprises:

performing, for each in the plurality of ADC channels other than the reference channel, an iterative calculation on the timing skew adjustment amount corresponding to the each in the plurality of ADC channels other than the reference channel by using a preset adaptive algorithm, according to the first timing skew feature corresponding to the each in the plurality of ADC channels other than the reference channel and the pre-obtained correspondence relationship between the timing skew adjustment amount and the timing skew characteristic amount, and taking an iterative calculation result as the timing skew adjustment amount corresponding to the each in the plurality of ADC channels other than the reference channel;
wherein the adaptive algorithm comprises a formula:

$$D\mathrm{sk}_j(n+1) = D\mathrm{sk}_j(n) - \mu * \phi_j * \mathrm{sign}\ (R'(T_S))$$

$\mu$ is a preset adjustment coefficient, and sign $(R'(T_S))$ is a sign bit of $R'(T_S)$, the $\phi_j$ represents the timing skew characteristic amount corresponding to the $j_{th}$ channel, $D\mathrm{sk}_j(n)$ represents an actual sampling timing skew amount of the $j_{th}$ channel in a $n_{th}$ adjustment, and $D\mathrm{sk}_j(n+1)$ represents an actual sampling timing skew amount of the $j_{th}$ channel in a $n+1_{th}$ adjustment; in response to a spectrum of the analog signal located in an even-numbered Nyquist region, sign $(R'(T_S))$ =1, in response to the spectrum of the analog signal located in an odd-numbered Nyquist region, sign $(R'(T_S))$=-1.

**9.** The method according to claim 6, wherein, before calculating the timing skew adjustment amount corresponding to each in the plurality of ADC channels, according to the first timing skew characteristic amount corresponding to each in the plurality of ADC channels and the pre-obtained correspondence relationship between the timing skew characteristic amount and the timing skew adjustment amount, the method further comprises:

obtaining a second timing skew characteristic amount $\phi_{old}$ corresponding to each in the plurality of ADC channels;
obtaining the first timing skew characteristic amount ($\phi_{new}$ corresponding to each in the plurality of ADC channels after the sampling time of each in the plurality of ADC channels is adjusted according to a preset timing skew adjustment amount $\Delta D\mathrm{sk}$;
calculating the unknown constant $R'(T_S)$ according to the first timing skew characteristic amount ($\phi_{new}$, the second timing skew characteristic amount $\phi_{old}$, the preset timing skew adjustment amount $\Delta D\mathrm{sk}$, and the correspondence relationship between the timing skew characteristic amount and the timing skew adjustment amount: $\Delta\phi = R'(T_S) * \Delta D\mathrm{sk}$, wherein $\Delta\Phi = \phi_{new} - \phi_{old}$;
calculating the timing skew adjustment amount corresponding to each in the plurality of ADC channels according to the first timing skew characteristic amount corresponding to each in the plurality of ADC channels and the pre-obtained correspondence relationship between the timing skew adjustment amount and the timing skew characteristic amount comprises:

performing, for each in the plurality of ADC channels other than the reference channel, an iterative calculation on the timing skew adjustment amount corresponding to the each in the plurality of ADC channels other than the reference channel by using a preset adaptive algorithm, according to the first timing skew feature corresponding to the each in the plurality of ADC channels other than the reference channel and the pre-obtained correspondence relationship between the timing skew adjustment amount and the timing skew characteristic amount, and taking an iterative calculation result as the timing skew adjustment amount corresponding to the each in the plurality of ADC channels other than the reference channel;
wherein the adaptive algorithm comprises a formula:

$$Dsk_j(n+1) = Dsk_j(n) - \mu * \phi_j * \text{sign} \ (R'(T_S))$$

$\mu$ is a preset adjustment coefficient, and $\phi_j$ represents a timing skew feature amount corresponding to the $j_{th}$ channel, $Dsk_j(n)$ represents an actual sampling timing skew amount of the $j_{th}$ channel in a $n_{th}$ adjustment, and $Dsk_j(n + 1)$ represents an actual sampling timing skew of the $j_{th}$ channel in a $n+1_{th}$ adjustment.

10. A calibration apparatus for calibrating a sampling timing skew between channels of a TIADC, wherein the calibration apparatus comprises a correlation value calculation unit, a timing skew adjustment calculation unit and a calibration unit;

the correlation value calculation unit is configured to calculate, for every two adjacent channels in the plurality of ADC channels, a correlation value between digital signals of every two adjacent channels according to the digital signals output by every two adjacent channels;

the timing skew adjustment calculation unit is configured to calculate a timing skew adjustment amount corresponding to the sampling timing skew of each in the plurality of ADC channels relative to a reference channel according to the correlation value corresponding to every two adjacent channels in the plurality of ADC channels, wherein the reference channel is any designated channel among the plurality of ADC channels;

the calibration unit is configured to calibrate the sampling timing skew of each in the plurality of ADC channels relative to the reference channel according to the timing skew adjustment amount corresponding to each in the plurality of ADC channels.

11. A TIADC, comprising a plurality of ADC channels and the calibration apparatus according to claim 10.

12. An electronic device, comprising:

one or more processors;

a memory storing one or more programs that, when executed by the one or more processors, cause the one or more processors to perform the calibration method according to any one of claims 1 to 9;

one or more input/output (I/O) interfaces, which connecting the one or more processors to the memory, and is configured to realize information interaction between the one or more processors and the memory.

13. A computer-readable medium storing a computer program that, when executed, performs the calibration method according to any one of claims 1 to 9.

11 — Calculates, for each two adjacent channels in multiple analog to digital converter, ADC, channels, a correlation value between digital signals of two adjacent channels, according to digital signals output by every two adjacent channels

12 — Calculates a time offset adjustment amount corresponding to a sampling time offset of each of the multiple channels relative to a reference channel according to the correlation value corresponding to every two adjacent channels

13 — Calibrates the sampling time offset of each of the multiple ADC channels relative to the reference channel according to the time offset adjustment amount corresponding to each of the multiple ADC channels

**FIG. 1**

21 — Obtains digital signals output by each of the multiple ADC channels according to input analog signals

22 — Calculates, for every two adjacent channels in the multiple ADC channels, a correlation value between digital signals of two adjacent channels, according to the digital signals output by every two adjacent channels

23 — Calculates a time offset adjustment amount corresponding to the sampling time offset of each of the multiple ADC channels relative to the reference channel according to the correlation value corresponding to every two adjacent channels

24 — Calibrates the sampling time offset of each of the Multiple ADC channels relative to the reference channel according to the time offset adjustment amount corresponding to each of the multiple ADC channels

**FIG. 2**

221

For every two adjacent channels in the multiple ADC channels, calculates multiple products of the digital signals of every two adjacent channels to obtain multiple product results corresponding to every two adjacent channels

222

Calculates an expected value corresponding to every two adjacent channels according to the multiple product results corresponding to every two adjacent channels

223

Calculates the correlation value between the digital signals of every two adjacent channels by using the expected value corresponding to every two adjacent channels and a preset autocorrelation function

**FIG. 3**

231

Calculates a first time offset feature amount corresponding to the sampling time offset of each of the multiple ADC channels relative to the reference channel according to the correlation value of every two adjacent channels and a pre-obtained correspondence relationship between the correlation value and the time offset feature amount

232

Calculates the time offset adjustment amount corresponding to each of the multiple ADC channels according to the first time offset feature amount corresponding to each of the multiple ADC channels and a pre-obtained correspondence relationship between the time offset feature amount and the time offset adjustment amount

**FIG. 4**

2301 — Constructs a correlation value matrix, where the correlation value matrix includes a column vector formed by the correlation value of every two adjacent channels in the multiple ADC channels

2302 — Performs a first-order Taylor series expansion on the correlation value of every two adjacent channels in the multiple ADC channels in the correlation value matrix Rm to obtain a corresponding expansion matrix

2303 — Performs a matrix decomposition on the expansion matrix to obtain a decomposition matrix, where the decomposition matrix is a product of a coefficient matrix A and a time offset feature amount matrix

2304 — Determines the correspondence relationship between the correlation value and the time offset feature amount according to the correlation value matrix and the decomposition matrix

**FIG. 5**

2321 — Obtains a second time offset feature amount corresponding to each of the multiple ADC channels

2322 — Obtains a first time offset feature amount corresponding to each of the multiple ADC channels after the sampling time of each of the multiple ADC channels is adjusted according to a preset time offset adjustment amount

2323 — Calculates the unknown constant according to the first time offset feature amount , the second time offset feature amount , the preset time offset adjustment amount , and the correspondence relationship between the time offset feature amount and the time offset adjustment amount

**FIG. 6**

**FIG. 7**

**FIG. 8**

**FIG. 9**

**FIG. 10**

**FIG. 11**

**FIG. 12**

**FIG. 13**

<table>
<tr><td colspan="2"><strong>INTERNATIONAL SEARCH REPORT</strong></td><td>International application No.<br><strong>PCT/CN2021/096555</strong></td></tr>
</table>

**A. CLASSIFICATION OF SUBJECT MATTER**

H03M 1/10(2006.01)i

According to International Patent Classification (IPC) or to both national classification and IPC

**B. FIELDS SEARCHED**

Minimum documentation searched (classification system followed by classification symbols)

H03M

Documentation searched other than minimum documentation to the extent that such documents are included in the fields searched

Electronic data base consulted during the international search (name of data base and, where practicable, search terms used)

CNPAT, WPI, EPODOC, CNKI, IEEE, 百度: 时间交织, 转换器, 通道, 采样, 偏差, 时间, 校准, ADC, time interleaving, path, analog, converter, sample, error, calibration

**C. DOCUMENTS CONSIDERED TO BE RELEVANT**

| Category* | Citation of document, with indication, where appropriate, of the relevant passages | Relevant to claim No. |
|---|---|---|
| Y | CN 103312329 A (UNIVERSITY OF ELECTRONIC SCIENCE AND TECHNOLOGY OF CHINA) 18 September 2013 (2013-09-18)<br>description, paragraphs [0006]-[0025] | 1, 10-13 |
| Y | CN 102739252 A (MAXIM INTEGRATED PRODUCTS) 17 October 2012 (2012-10-17)<br>description, paragraphs [0008]-[0058] | 1, 10-13 |
| A | CN 111064469 A (BEIJING UNIVERSITY OF TECHNOLOGY) 24 April 2020 (2020-04-24)<br>entire document | 1-13 |
| A | CN 104993828 A (WUXI BIXUN TECHNOLOGY CO., LTD.) 21 October 2015 (2015-10-21)<br>entire document | 1-13 |
| A | US 10804919 B1 (MICROSOFT TECHNOLOGY LICENSING, LLC.) 13 October 2020 (2020-10-13)<br>entire document | 1-13 |

☐ Further documents are listed in the continuation of Box C. ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 August 2021** | **01 September 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2021/096555**

| Patent document cited in search report | | | Publication date (day/month/year) | Patent family member(s) | | | Publication date (day/month/year) |
|---|---|---|---|---|---|---|---|
| CN | 103312329 | A | 18 September 2013 | None | | | |
| CN | 102739252 | A | 17 October 2012 | DE | 102012206011 | A1 | 18 October 2012 |
| | | | | US | 2012262318 | A1 | 18 October 2012 |
| CN | 111064469 | A | 24 April 2020 | None | | | |
| CN | 104993828 | A | 21 October 2015 | None | | | |
| US | 10804919 | B1 | 13 October 2020 | WO | 2021061218 | A1 | 01 April 2021 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010575519